# EUROPÄISCHE PATENTSCHRIFT

(11) **EP 0 985 256 B1**
(45) Veröffentlichungstag und Bekanntmachung des Hinweises auf die Patenterteilung: **06.05.2004**
(21) Anmeldenummer: 99917769.4
(22) Anmeldetag: 03.03.1999
(51) Int. Cl.: H01S 5/10

(54) **VERTIKALRESONATOR-LASERDIODE UND VERFAHREN ZU DEREN HERSTELLUNG**
VERTICAL RESONATOR LASER DIODE AND METHOD FOR THE PRODUCTION THEREOF
DIODE LASER A RESONATEUR VERTICAL ET SON PROCEDE DE PRODUCTION

(30) Priorität: 27.03.1998 DE 19813727
(43) Veröffentlichungstag der Anmeldung: 15.03.2000
(73) Patentinhaber: Infineon Technologies AG, 81669 München (DE)
(72) Erfinder: WIPIEJEWSKI, Torsten, D-93049 Regensburg (DE)
(74) Vertreter: Gross, Felix, Dr.
(86) Internationale Anmeldenummer: PCT/DE1999/000570
(87) Internationale Veröffentlichungsnummer: WO 1999/050939

(56) Entgegenhaltungen:
- EP-A1- 0 788 202
- EP-A1- 0 791 990

## Beschreibung

Die vorliegende Erfindung bezieht sich auf eine Vertikalresonator-Laserdiode (VCSEL), bei der zwischen einer ersten Bragg-Reflektor-Schichtenfolge und einer zweiten Bragg-Reflektor-Schichtenfolge, von denen jede eine Mehrzahl von Spiegelpaaren aufweist, eine aktive Schichtenfolge zur Erzeugung von Laserstrahlung angeordnet ist. Die beiden Bragg-Reflektor-Schichtenfolgen bilden einen Laser-Resonator und sind zusammen mit der aktiven Schichtenfolge zwischen einer ersten und einer zweiten elektrischen Kontaktschicht angeordnet. Eine der beiden Bragg-Reflektor-Schichtenfolgen ist für die in der aktiven Schichtenfolge erzeugten Laserstrahlung teildurchlässig. An mindestens einer der beiden Bragg-Reflektor-Schichtenfolgen ist eine Stromeinschnürungseinrichtung (im Weiteren "Stromapertur" genannt) vorgesehen, die zur Bündelung des im Betrieb der Laserdiode durch die aktive Schichtenfolge fließenden Betriebsstromes und damit zur Begrenzung des Querschnittes des gepumpten aktiven Bereiches der aktiven Schichtenfolge dient. Die Stromapertur weist mindestens eine Aperturschicht, die zwischen einer der elektrischen Kontaktschichten und der aktiven Schichtenfolge angeordnet ist. Weiterhin bezieht sich die Erfindung auf ein Verfahren zur Herstellung einer solchen Vertikalresonator-Laserdiode.

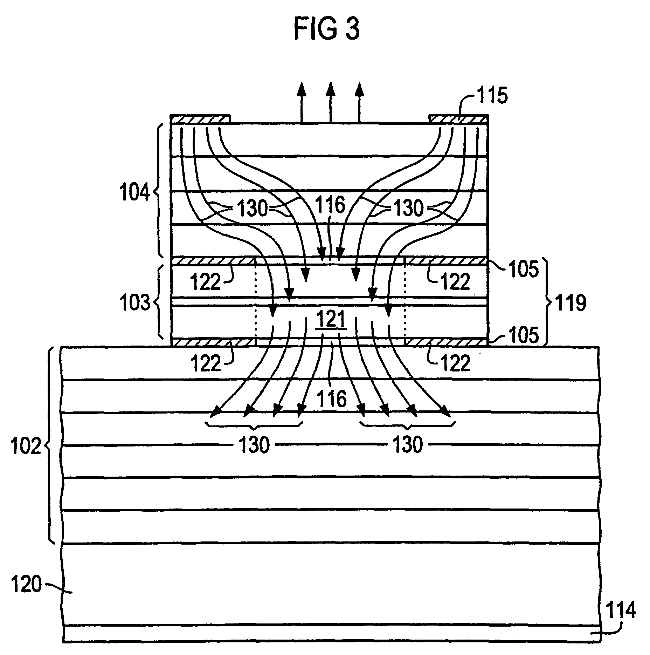

Aus der US 5,493,577 sind derartige Vertikalresonator-Laserdioden mit Stromapertur 119 bekannt. Ein Beispiel hieraus ist schematisch in Fig. 3 dargestellt. Bei diesem wird die Stromeinschnürung (der Stromfluß ist durch die Pfeile 130 angedeutet) auf den gewünschten gepumpten Bereich 121 der aktiven Schichtenfolge 103 mittels zweier dünner AlAs- oder AlGaAS-Aperturschichten 105 bewirkt, die bis auf die jeweilige Stromdurchlaßöffnung 116 oxidiert sind.

Die beiden Aperturschichten 105 sind auf einander gegenüberliegenden Seiten der aktiven Schichtenfolge 103 jeweils zwischen dieser und der dort vorgesehenen Bragg-Reflektor-Schichtenfolge 102,104 angeordnet. Letztere bestehen im Wesentlichen jeweils aus mehreren Spiegelpaaren, von denen jedes zwei AlGaAs-Schichten mit unterschiedlichen Bandgaps aufweist.

In den oxidierten ringartigen Bereichen 122, die die Größe und Form der Stromdurchlaßöffnungen 116 definieren, besitzen die AlAs- oder AlGaAS-Aperturschichten 105 einen sehr hohen elektrischen Widerstand, so daß der Pumpstrom 130 im Wesentlichen nur im Bereich der Stromdurchlaßöffnungen und damit im gewünschten gepumpten Bereich 121 durch die aktive Schichtenfolge 103 fließt.

Hinsichtlich einer einfachen Herstellung derartiger Vertikalresonator-Laserdioden weisen die AlAs- oder AlGaAs-Aperturschichten 105 einen höheren Al-Gehalt auf als die AlGaAs-Schichten der Spiegelpaare der Bragg-Reflektor-Schichtenfolgen 102,104.

Die laterale Oxidationsrate von AlₓGa₁₋ₓAs-Schichten bei Temperung in feuchter Atmosphäre hängt nämlich vom Al-Gehalt ab (je höher der Al-Gehalt umso höher ist die Oxidationsrate). Aus diesem Grund lassen sich die AlAs- oder AlGaAs-Aperturschichten 105, wie in US 5,493,577 beschrieben, auf einfache Weise nach dem Herstellen der Laserdioden-Schichtstruktur mit aktiver Schichtenfolge 103, Bragg-Reflektor-Schichtenfolgen 102,104 und AlAs- oder AlGaAs-Schichten für die Aperturschichten 105 durch Oxidation der gesamten Schichtstruktur in feuchter Atmosphäreherstellen.

Darüberhinaus bewirken die dünnen AlAs- oder AlGaAs-Aperturschichten 105 im Laserresonator nur geringe optische Verluste. Folglich können Vertikalresonator-Laserdioden mit sehr großer Effizienz und kleinen Schwellströmen hergestellt werden.

Ein Nachteil dieser bekannten Struktur von Vertikalresonator-Laserdioden ist aber, daß im Betrieb eine starke Stromüberhöhung an den Rändern der Stromdurchlaßöffnungen 116 auftritt. Diese Stromüberhöhung bewirkt eine sehr starke lokale Erwärmung der Bragg-Reflektor-Schichtenfolgen 102,104 und der aktiven Schichtenfolge 103 im Bereich dieser Ränder, was die Alterung des Laserdioden-Bauelementes beschleunigt. Darüberhinaus besteht auch die Gefahr, daß die lokal sehr hohe Stromdichte zur Generierung und Wanderung von Kristalldefekten führt, was die Lebensdauer und Zuverlässigkeit der Vertikalresonator-Laserdioden verringert.

Die Aufgabe der vorliegenden Erfindung besteht folglich darin, eine Vertikalresonator-Laserdiode zu entwickeln, bei der lokale Stromüberhöhungen minimiert sind. Darüberhinaus soll ein Verfahren für eine einfache Herstellung derartiger Vertikalresonator-Laserdioden entwickelt werden.

Diese Aufgabe wird durch eine Vertikalresonator-Laserdiode mit den Merkmalen des Anspruches 1 gelöst. Vorteilhafte Weiterbildungen und bevorzugte Ausführungsformen der erfindungsgemäßen Vertikalresonator-Laserdiode sind Gegenstand der Unteransprüche 2 bis 6. Ein bevorzugtes Verfahren zum Herstellen der Vertikalresonator-Laserdiode ist Gegenstand des Anspruches 7.

Demgemäß ist bei der Vertikalresonator-Laserdiode der eingangs genannten Art vorgesehen, daß die Stromapertur von einer Mehrzahl von einzelnen, voneinander getrennten Aperturschichten mit unterschiedlich großen Stromdurchlaßöffnungen gebildet ist, die zwischen einer der elektrischen Kontaktschichten und der aktiven Schichtenfolge angeordnet sind, und die Größen der Stromdurchlaßöffnungen dieser Aperturschichten in Richtung von der aktiven Schichtenfolge weg zur elektrischen Kontaktschicht hin (schrittweise) zunehmen. Insbesondere nehmen die Größen der Stromdurchlaßöffnungen bei mehr als zwei Aperturschichten ausgehend von einer kleinsten Stromdurchlaßöffnung, benachbart der aktiven Schichtenfolge, hin zu einer größten Stromdurchlaßöffnung, benachbart der elektrischen Kontaktschicht, permanent zu.

In dieser Vertikalresonator-Laserdiode bestimmt die von der aktiven Schichtenfolge aus gesehen erste Aperturschicht mit der kleinsten Stromdurchlaßöffnung die Größe des gepumpten aktiven Bereichs. Die von der aktiven Schichtenfolge aus gesehen dieser ersten Aperturschicht nachgeordnete(n) Aperturschicht(en) mit größerer Stromdurchlaßöffnung verringern den Effekt der Stromüberhöhung in der Vertikalresonator-Laserdiode, weil der Strom bereits vor dem Erreichen der kleinsten Stromdurchlaßöffnung schrittweise zur optischen Achse (Strahlachse) der Laserdiode hin gedrängt wird, die durch den gepumpten aktiven Bereich verläuft.

Bei einer bevorzugten Ausführungsform bestehen die Aperturschichten aus oxidierbarem elektrisch leitendem Material, das eine höhere Oxidationsrate aufweist als die Bragg-Reflektor-Schichtenfolgen und das bis auf den Bereich der jeweiligen Stromdurchlaßöffnung oxidiert ist. Derartige Aperturschichten lassen sich, wie weiter oben bereits beschrieben, auf einfache Weise mittels Tempern in sauerstoffhaltiger Atmosphäre herstellen.

Bei einer besonders bevorzugten Ausführungsform der Vertikalresonator-Laserdiode weisen die Aperturschichten AlₓGa₁₋ₓAs mit 0.8 < x ≤ 1 auf. Bei derartigen Schichten hängt die laterale Oxidationsgeschwindigkeit bei Temperung in feuchter Atmosphäre vom Al-Gehalt (je höher der Al-Gehalt umso höher ist die Oxidationsrate) und, bei sehr dünnen Schichten (Schichtdicken z. B. 5 - 10 nm), auch von der Schichtdicke ab. Mit "lateraler" Oxidationsgeschwindigkeit ist gemeint, die Oxidationstiefe bei einer von zwei Schichten sandwichartig eingeschlossenen zu oxidierenden Schicht (hier die AlₓGa₁₋ₓAs-Aperturschicht), gemessen von deren freien Stirnfläche her, pro Zeiteinheit, wobei die beiden "Sandwich"-Schichten, die die zu oxidierende Schicht einschließen, nicht oder deutlich langsamer oxidieren.

Bei einer weiterhin besonders bevorzugten Ausführungsform der Vertikalresonator-Laserdiode weisen die Aperturschichten alle im Wesentlichen die gleiche Zusammensetzung auf und werden deren Schichtdicken in Richtung von der aktiven Schichtenfolge weg zur elektrischen Kontaktschicht hin immer geringer. Bei dieser Ausführungsform lassen sich die Oxidationstiefen in den verschiedenen Aperturschichten vorteilhafterweise auf einfache Weise genau einstellen.

Besonders bevorzugt werden die Aperturschichten in einer der Bragg-Reflektor-Schichtenfolgen angeordnet und sind die Spiegelpaare dieser Bragg-Reflektor-Schichtenfolge jeweils aus einer Al_{z}Ga_{1-z}As-Spiegelschicht mit einem Brechungsindex n_{z} und einer Dicke dz und einer weiteren Spiegelschicht mit einem geringeren Brechungsindex als derjenige der Al_{z}Ga_{1-z}As-Spiegelschicht zuammengesetzt, wobei sich die weitere Spiegelschicht jeweils aus einer AlₓGa₁₋ₓAs-Schicht 25 mit einem Brechungsindex nₓ und einer Dicke dx und einer Al_{y}Ga_{1-y}As-Schicht 26 mit einem Brechungsindex n_{y} und einer Dicke dy mit unterschiedlichem Al-Gehalt x und y zusammensetzt, x>y>z ist und die Dicke der Einzelschichten so bemessen ist, daß nₓdₓ+n_{y}d_{y}+n_{z}d_{z}≅λ/2 gilt mit λ: Laseremissionswellenlänge der Laserdiode.

Ein bevorzugtes Verfahren zum Herstellen der zuletzt erläuterten Vertikalresonator-Laserdiode gemäß der Erfindung weist folgende Verfahrensschritte auf:
- Herstellen der Bragg-Reflektor-Schichtenfolge mit einer Mehrzahl von Spiegelpaaren und einer Mehrzahl von jeweils zwischen zwei Spiegelpaaren angeordneten AlₓGa₁₋ₓAs-Aperturschichten mit 0.8 < x ≤ 1 deren Schichtdicken in Richtung von der aktiven Schichtenfolge weg zur elektrischen Kontaktschicht hin immer geringer werden und zwischen 5 und 10 nm liegen;
- Oxidieren der Aperturschichten von deren freiliegenden Oberflächen (Stirnflächen) aus nach Innen durch Tempern der Bragg-Reflektor-Schichtenfolge mit den Aperturschichten in sauerstoffhaltiger Athmosphäre.

Die erfindungsgemäße Vertikalresonator-Laserdiode wird im Folgenden anhand eines Ausführungsbeispieles in Verbindung mit den Figuren 1 bis 3 näher erläutert.
Es zeigen:
Figur 1 eine schematische Darstellung eines Schnittes durch das Ausführungsbeispiel,
Figur 2 eine schematische Darstellung eines Schnittes durch eine Braggreflektor-Schichtenfolge mit Aperturschichten und
Figur 3 eine schematische Darstellung einer Vertikalresonator-Laserdioden gemäß dem Stand der Technik.

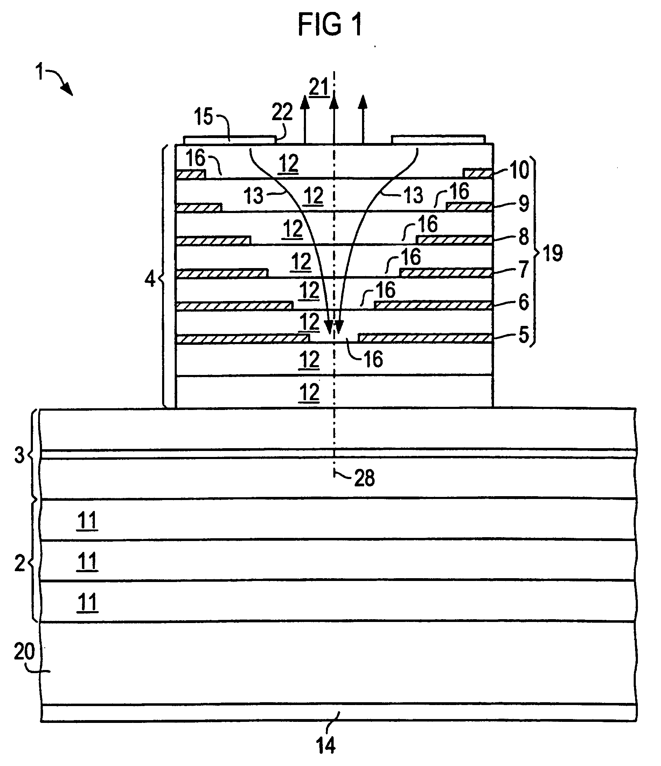

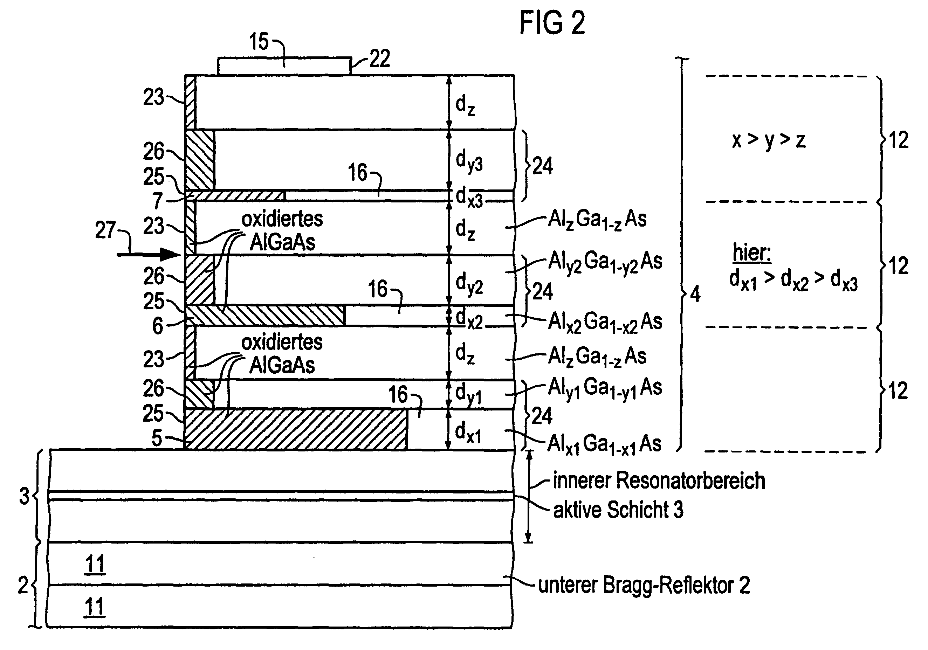

Das Ausführungsbeispiel von Figur 1 und 2 (Fig. 2 ist eine schematische Darstellung eines oberen Bragg-Reflektors einer Vertikalresonator-Laserdioden mit einer Emissionswellenlänge von ungefähr 850nm) weist auf:
- Ein Halbleitersubstrat 20, auf dem eine Mehrzahl von epitaktisch aufgewachsenen Halbleiterschichten aufgebracht ist, die eine erste Bragg-Reflektorschichtenfolge 2 über dem Substrat 20 bildet. Diese erste Bragg-Reflektorschichtenfolge 2 wird im Weiteren mit "unterer Braggreflektor 2" bezeichnet.
- Eine aktive Schichtenfolge 3 über dem unteren Braggreflektor 2, in der im Betrieb die Laserstrahlung 21 erzeugt wird.
- Eine zweite Bragg-Reflektorschichtenfolge 4 über der aktiven Schichtenfolge 3, die einer Mehrzahl von epitaktisch aufgewachsenen Halbleiterschichten aufweist. Diese zweite Bragg-Reflektorschichtenfolge 4 wird im Weiteren mit "oberer Braggreflektor 4" bezeichnet.
- Eine erste Kontaktschicht 14 (untere Kontaktschicht) an der dem unteren Braggreflektor 2 gegenüberliegenden Seite des Substrats 20 und eine zweite Kontaktschicht 15 (obere Kontaktschicht) auf dem oberen Braggreflektor 4, die eine Öffnung 22 aufweist, durch die die Laserstrahlung 21 aus der Laserdiode 1 ausgekoppelt wird.
- Eine Mehrzahl von Aperturschichten 5 - 10 mit unterschiedlich großen Stromdurchlaßöffnungen 16, wobei die Größen der Stromdurchlaßöffnungen 16 dieser Aperturschichten 5 - 10 in Richtung von der aktiven Schichtenfolge 3 weg zur elektrischen Kontaktschicht 15 hin zunehmen. Diese Aperturschichten bilden zusammen die Stromapertur 19.

Die einzelnen Komponenten bestehen bevorzugt aus folgenden Schichten und Materialien:

| | |
|---|---|
| Halbleitersubstrat 20 | GaAs, z. B. n-dotiert |
| unterer Braggreflektor 2 | Spiegelpaare 11 aus Al_{y}Ga_{1-y}As, z. B. n-dotiert |
| aktiven Schichtenfolge 3 | aktive Quantenfilme mit den entsprechenden Barrieren- und Mantel(Cladding)-Schichten (Material abhängig von der gewünschten Wellenlänge der Laserstrahlung, bevorzugt III/V- oder II/VI-Halbleitermaterial) |
| oberer Braggreflektor 4 | Spiegelpaare 12 aus Al_{z}Ga_{1-z}As, z. B. p-dotiert |
| Kontaktschichten 14,15 | Kontaktmetallisierung, z.B. aus AuBe/Ti/Au bzw. AuGe/Ti/Au |
| Aperturschichten 5 - 10 | AlₓGa₁₋ₓAs mit 0.8 < x ≤ 1 (teilweise oxidiert) und Schichtdicken zwischen 5 und 10 nm. |

Besonders bevorzugt weisen die Aperturschichten 5 - 10 alle im Wesentlichen die gleiche Zusammensetzung auf. Ihre Schichtdicken dx werden gesehen von der aktiven Schichtenfolge 3 in Richtung oberer Kontaktschicht 15 immer geringer. Sie sind jeweils bis auf den Bereich der jeweiligen Stromdurchlaßöffnung 16 oxidiert und weisen daher außerhalb der Stromdurchlaßöffnung 16 einen sehr hohen elektrischen Widerstand auf. Über eine Variation der Schichtdicke dx läßt sich, wie weiter oben bereits erwähnt, die Größe der Stromdurchlaßöffnung 16 einer Aperturschichten 5 - 10 einstellen. Die Kontrollierbarkeit der Größe Stromdurchlaßöffnung 16 ist über die Variation der Schichtdicke besser als über die Variation der Komposition x in den Aperturschichten 5 - 10.

Der obere Bragg-Reflektor 4 enthält Al_{z}Ga_{1-z}As-Spiegelschichten 23 mit einem relativ hohen Brechungsindex n_{z} und einem dementsprechend geringen Al-Gehalt z. Die Schichtdicke d_{z} entspricht idealerweise einem Viertel der Laseremissionswellenlänge λ in dieser Al_{z}Ga_{1-z}As-Schicht 23 (d_{z} = λ(4 n_{z})).

Die Spiegelschichten 24 des oberen Braggreflektors 4 mit einem geringeren Brechungsindex als derjenige der Al_{z}Ga_{1-z}As-Spiegelschichten 23 setzen sich aus jeweils einer AlₓGa₁₋ₓAs-Schicht 25 mit einem Brechungsindex nₓ und einer Al_{y}Ga_{1-y}As-Schicht 26 mit einem Brechungsindex n_{y} mit unterschiedlichem Al-Gehalt x und y zusammen, wobei x>y>z ist. Die Dicke der Einzelschichten ist so bemessen, daß nₓdₓ+n_{y}d_{y}+n_{z}d_{z}=λ/2 ist.

Jeweils zwei Spiegelschichten 23,24 mit hohem und niedrigem Brechungsindex bilden die Spiegelpaare 12 des oberen Bragg-Reflektors 4. In der vereinfachten Darstellung der Figur 2 werden Zwischenschichten oder graduelle Übergänge zwischen den Einzelschichten, die zur Verringerung des elektrischen Widerstandes typischerweise vorgesehen werden, nicht berücksichtigt.

Alle AlGaAs-Schichten 23,25,26 des oberen Braggreflektors 4 sind von deren Seitenfläche her ins Innere des Braggreflektors hinein oxidiert (angedeutet durch den Pfeil 27). Die AlₓGa₁₋ₓAs-Schichten, die den höchsten Al-Gehalt besitzen, weisen die größte Oxidationstiefe auf, während die Al_{y}Ga_{1-y}Asund Al_{z}Ga_{1-z}As-Schichten weit weniger tief ins Innere des oberen Braggreflektors 4 oxidiert sind. Die oxidierten AlₓGa₁₋ₓ As-Schichten definieren demzufolge die Strumdurchlaßöffnungen 16 der Aperturschichten 5 - 10.

Die AlₓGa₁₋ₓAs-Schicht 25 mit der größten Dicke dₓ₁ oxidiert schneller als die dünneren AlₓGa₁₋ₓAs-Schichten 25 mit den Schichtdicken dₓ₂, dₓ₃ ... usw. Über die Schichtdicken dₓ kann so die Tiefe der Oxidationsfront und damit der Durchmesser der Stromdurchlaßöffnungen 16 eingestellt werden. Die Lage der AlₓGa₁₋ₓAs-Schicht 25 mit der größten Dicke dₓ₁ muß für die Vertikalresonator-Laserdioden optimiert werden.

Zwischen der AlₓGa₁₋ₓAs-Schicht 25 mit der größten Dicke dₓ₁ und der aktiven Schichtenfolge können, wie in Figur 1 dargestellt, weitere Spiegelpaare 12 liegen. Diese Spiegelpaare 12 könnten auch wiederum AlₓGa₁₋ₓAs-Schichten enthalten, die allerdings eine Dicke kleiner als dₓ₁ aufweisen würden.

In Vertikalresonator-Laserdioden bestimmt die kleinste Stromdurchlaßöffnungen 16 der Aperturschicht 5 mit der größten Dicke dₓ₁ die Größe des gepumpten aktiven Bereichs, wenn von einer Stromaufweitung hinter der Stromdurchlaßöffnungen 16 abgesehen wird. Über dieser Aperturschicht 5 werden beispielsweise im oberen Bragg-Reflektor 4 eine oder mehrere zusätzliche Aperturschichten 6 - 10 mit einem größeren Durchmesser der zugehörigen Stromdurchlaßöffnungen 16 angeordnet. Die zusätzlichen Aperturschichten 6 - 10 verringern den Effekt der Stromüberhöhung (Current Crowding) in der Vertikalresonator-Laserdiode, weil der Strom bereits vor dem Erreichen der kleinsten Stromdurchlaßöffnung 16 der Aperturschicht 5 zur Mittelachse 28 des oberen Braggreflektors 4 hin gedrängt wird.

Die Größe der Stromdurchlaßöffnungen 16 der Aperturschichten 5 - 10 wird hier besonders bevorzugt über deren Dicken dₓ₁, dₓ₂, dₓ₃ ... der AlₓGa₁₋ₓAs-Schichten 25 eingestellt, was eine bessere Kontrollierbarkeit der Oxidationstiefen bietet als eine prinzipiell auch mögliche Variation des Al-Gehalts dieser Schichten. Das epitaktische Wachstum ist einfacher, weil die Komposition der Verbindungshalbleiter konstant bleibt und nur die Wachstumszeit, variiert wird. Die konstante Komposition gewährleistet auch einen gleichbleibenden Brechungsindex, was für die Kontrolle der optischen Schichtdicken im Laserresonator von Vorteil ist.

Das oben beschriebene Ausführungsbeispiel beschränkt sich auf die Anordnung einer Stromapertur 19 nur im oberen Braggreflektor 4. Es ist aber ebenso möglich, nur im unteren Braggreflektor 2 eine oder in beiden Braggreflektoren 2 und 4 jeweils eine Stromapertur 19 anzuordnen.

Bei einem bevorzugtes Verfahren zum Herstellen der Vertikalresonator-Laserdiode gemäß dem Ausführungsbeispiel werden zunächst auf das Substrat 20 der untere Braggreflektor 2, die aktive Schichtenfolge 3 und der obere Braggreflektor 4 epitaktisch aufgebracht. Danach werden die Kontaktschichten 14 und 15 auf das Substrat 2 bzw. auf den oberen Braggreflektor 4 abgeschieden. Nachfolgend erfolgt eine Oxidation 27 dieser gesamten Schichtstruktur mittels Temperung in feuchter Atmosphäre.

## Patentansprüche

1. Vertikalresonator-Laserdiode (1), bei der
- zwischen einer ersten Bragg-Reflektor-Schichtenfolge (2) und einer zweiten Bragg-Reflektor-Schichtenfolge (4), von denen jede eine Mehrzahl von Spiegelpaaren (11,12) aufweist, eine aktive Schichtenfolge (3) zur Erzeugung von Laserstrahlung angeordnet ist,
- die beiden Bragg-Reflektor-Schichtenfolgen (2,4) einen Laser-Resonator bilden
- die beiden Bragg-Reflektor-Schichtenfolgen (2,4) und die aktive Schichtenfolge (3) zwischen einer ersten (14) und einer zweiten elektrischen Kontaktschicht (15) angeordnet sind,
- eine der beiden Bragg-Reflektor-Schichtenfolgen (2,4) für die in der aktiven Schichtenfolge (3) erzeugten Laserstrahlung teildurchlässig ist,
- mindestens auf einer Seite der aktiven Schichtenfolge (3) eine Stromapertur (19) zur Begrenzung des gepumpten aktiven Bereiches der aktiven Schichtenfolge (3) durch Bündelung des im Betrieb der Vertikalresonator-Laserdiode (1) durch die aktive Schichtenfolge (3) fließenden Betriebsstromes (13) vorgesehen ist, und
- die Stromapertur (19) von mindestens einer Aperturschicht (5) gebildet ist, die zwischen einer der elektrischen Kontaktschichten (14,15) und der aktiven Schichtenfolge (3) angeordnet ist,
**dadurch gekennzeichnet, daß**
- die Stromapertur (19) von einer Mehrzahl von einzelnen Aperturschichten (5 - 10) mit unterschiedlich großen Stromdurchlaßöffnungen (16) gebildet ist, und die Größen der Stromdurchlaßöffnungen (16) dieser Aperturschichten (5 - 10) in Richtung von der aktiven Schichtenfolge (3) weg zur elektrischen Kontaktschicht (14,15) hin zunehmen.

2. Vertikalresonator-Laserdiode (1) nach Anspruch 1,
**dadurch gekennzeichnet, daß**
- die Aperturschichten (5-10) oxidierbares elektrisch leitendes Material aufweisen und jeweils bis auf den Bereich der jeweiligen Stromdurchlaßöffnung (16) oxidiert sind.

3. Vertikalresonator-Laserdiode (1) nach Anspruch 2,
**dadurch gekennzeichnet, daß**
- die Aperturschichten (5-10) AlₓGa₁₋ₓAs mit 0.8 < x ≤ 1 aufweisen.

4. Vertikalresonator-Laserdiode (1) nach Anspruch 3,
**dadurch gekennzeichnet, daß**
- alle Aperturschichten (5 - 10) im Wesentlichen die gleiche Zusammensetzung aufweisen und daß
- die Schichtdicken der Aperturschichten (5 - 10) in Richtung von der aktiven Schichtenfolge (3) weg zur elektrischen Kontaktschicht (14,15) hin immer geringer werden.

5. Vertikalresonator-Laserdiode (1) nach Anspruch 3 oder 4,
**dadurch gekennzeichnet, daß**
- die Aperturschichten (5 - 10) in einer der Bragg-Reflektor-Schichtenfolgen (4) angeordnet sind.

6. Vertikalresonator-Laserdiode (1) nach Anspruch 5,
**dadurch gekennzeichnet, daß**
- Spiegelpaare (12) dieser Bragg-Reflektor-Schichtenfolge (4) jeweils aus einer Al_{z}Ga_{1-z}As-Spiegelschicht (23) mit einem Brechungsindex n_{z} und einer Dicke dz und einer weiteren Spiegelschicht (24) mit einem geringeren Brechungsindex als derjenige der Al_{z}Ga_{1-z}As-Spiegelschicht (23) zuammengesetzt sind, wobei die weitere Spiegelschicht (24) jeweils aus einer AlₓGa₁₋ₓAs-Schicht 25 mit einem Brechungsindex nₓ und einer Dicke dx und einer Al_{y}Ga_{1-y}As-Schicht 26 mit einem Brechungsindex n_{y} und einer Dicke dy mit unterschiedlichem Al-Gehalt x und y zusammengesetzt und x>y>z ist und die Dicke der Einzelschichten so bemessen ist, daß nₓdₓ+n_{y}d_{y}+n_{z}d_{z}≅λ/2 gilt, mit λ: Laseremissionswellenlänge der Laserdiode.

7. Verfahren zum Herstellen einer Vertikalresonator-Laserdiode (1) nach einem der Ansprüche 3 bis 6, **gekennzeichnet durch** folgende Verfahrensschritte:
- Herstellen einer Bragg-Reflektor-Schichtenfolge (2,4) mit einer Mehrzahl von Spiegelpaaren (11,12) und einer Mehrzahl von Aperturschichten (5 - 10),
- Oxidieren der Aperturschichten (5 - 10) von deren freiliegenden Oberflächen aus nach Innen **durch** Tempern der Bragg-Reflektor-Schichtenfolge (2,4) mit den Aperturschichten (5 - 10) in sauerstoffreicher Athmosphäre.

## Claims

1. Vertical resonator laser diode (1), in which
- an active layer sequence (3) for generating laser radiation is arranged between a first Bragg reflector layer sequence (2) and a second Bragg reflector sequence (4), each of which has a plurality of mirror pairs (11,12),
- the two Bragg reflector layer sequences (2,4) form a laser resonator,
- the two Bragg reflector layer sequences (2,4) and the active layer sequence (3) are arranged between a first (14) and a second electrical contact layer (15),
- one of the two Bragg reflector layer sequences (2,4) is partially transmissive for the laser radiation generated in the active layer sequence (3),
- at least on one side of the active layer sequence (3), provision is made of a current aperture (19) for limiting the pumped active region of the active layer sequence (3) by concentrating the operating current (13) flowing through the active layer sequence (3) during operation of the vertical resonator laser diode (1), and
- the current aperture (19) is formed by at least one aperture layer (5) arranged between one of the electrical contact layers (14,15) and the active layer sequence (3),
**characterized in that**
- the current aperture (19) is formed by a plurality of individual aperture layers (5-10) having current passage openings (16) of different sizes, and the sizes of the current passage openings (16) of these aperture layers (5-10) increase in the direction away from the active layer sequence (3) towards the electrical contact layer (14,15).

2. Vertical resonator laser diode (1) according to Claim 1,
**characterized in that**
- the aperture layers (5-10) have oxidizable electrically conductive material and are oxidized in each case except for the region of the respective current passage opening (16).

3. Vertical resonator laser diode (1) according to Claim 2,
**characterized in that**
- the aperture layers (5-10) have AlₓGa₁₋ₓAs where 0.8 < x ≤ 1.

4. Vertical resonator laser diode (1) according to Claim 3,
**characterized in that**
- all of the aperture layers (5-10) have essentially the same composition, and **in that**
- the layer thicknesses of the aperture layers (5-10) become smaller and smaller in the direction away from the active layer sequence (3) towards the electrical contact layer (14,15).

5. Vertical resonator laser diode (1) according to Claim 3 or 4,
**characterized in that**
- the aperture layers (5-10) are arranged in one of the Bragg reflector layer sequences (4).

6. Vertical resonator laser diode (1) according to Claim 5,
**characterized in that**
- mirror pairs (12) of this Bragg reflector layer sequence (4) are each composed of an Al_{z}Ga_{1-z}As mirror layer (23) having a refractive index n_{z} and a thickness dz and a further mirror layer (24) having a smaller refractive index than that of the Al_{z}Ga_{1-z}As mirror layer (23), where the further mirror layer (24) is in each case composed of an AlₓGa₁₋ₓAs layer 25 having a refractive index nₓ and a thickness dx and an Al_{y}Ga_{1-y}As layer (26) having a refractive index n_{y} and a thickness dy with a different Al content x and y, and x>y>z and the thickness of the individual layers is dimensioned in such a way that nₓdₓ+n_{y}d_{y}+n_{z}d_{z}≡λ/2, where λ:laser emission wavelength of the laser diode.

7. Method for producing a vertical resonator laser diode (1) according to one of Claims 3 to 6,
**characterized by** the following method steps:
- production of a Bragg reflector layer sequence (2,4) with a plurality of mirror pairs (11,12) and a plurality of aperture layers (5-10),
- oxidation of the aperture layers (5-10) from their exposed surfaces inwards by heat-treating the Bragg reflector layer sequence (2,4) with the aperture layers (5-10) in an oxygen-rich atmosphere.

## Revendications

1. Diode (1) laser à résonateur vertical, dans laquelle
- il est interposé entre une première succession (2) de couches formant réflecteur de Bragg et une deuxième succession (4) de couches formant réflecteur de Bragg, dont chacune a une majorité de paires (11, 12) de miroirs, une succession (3) de couches actives de production de rayonnement laser,
- les deux successions (2, 4) de couches formant réflecteur de Bragg forment un résonateur laser,
- les deux successions (2, 4) de couches formant réflecteur de Bragg et la succession (3) de couches actives sont interposées entre une première (14) et une deuxième (15) couche électrique de contact,
- l'une des deux successions (2, 4) de couches formant réflecteur de Bragg est semi-transparente pour le rayonnement laser produit dans la succession (3) de couches actives,
- au moins d'un côté de la succession (3) de couches actives est prévue une ouverture (19) de courant pour limiter la zone active pompée de la succession (3) de couches actives par focalisation du courant (13) de fonctionnement passant, en fonctionnement de la diode (1) laser à résonateur vertical, dans la succession (3) de couches actives, et
- l'ouverture (19) de courant est formée d'au moins une couche (5) d'ouverture, qui est interposée entre l'une des couches (14, 15) de contact électrique et la succession (3) de couches actives,
**caractérisée en ce que**
- l'ouverture (19) de courant est formée d'une majorité de couches (5 à 10) d'ouverture ayant des ouvertures (16) de passage du courant de dimensions différentes et les dimensions des ouvertures (16) de passage du courant de ces couches (5 à 10) d'ouverture augmentent dans le sens allant de la succession (3) de couches actives à la couche (14, 15) électrique de contact.

2. Diode (1) laser à résonateur vertical suivant la revendication 1,
**caractérisée en ce que**
- les couches (5 à 10) d'ouverture ont de la matière oxydable et conductrice de l'électricité et sont oxydées respectivement à l'exception de la zone de l'ouverture (16) respective de passage du courant.

3. Diode (1) laser à résonateur vertical suivant la revendication 2,
**caractérisée en ce que**
- les couches (5 à 10) d'ouverture ont de l'AlₓGa₁₋ₓAs avec 0,8 < x 1.

4. Diode (1) laser à résonateur vertical suivant la revendication 3,
**caractérisée en ce que**
- toutes les couches (5 à 10) d'ouverture ont sensiblement la même composition et **en ce que**
- les épaisseurs des couches (5 à 10) d'ouverture deviennent de plus en plus petites dans le sens allant de la succession (3) de couches actives à la couche (14, 15) électrique de contact.

5. Diode (1) laser à résonateur vertical suivant la revendication 3 ou 4, **caractérisée en ce que**
- les couches (5 à 10) d'ouverture sont ménagées dans l'une des successions (4) de couches formant réflecteur de Bragg.

6. Diode (1) laser à résonateur vertical suivant la revendication 5, **caractérisée en ce que**
- des paires (12) de miroirs de cette succession (4) de couches formant réflecteur de Bragg sont composées respectivement d'une couche (23) de miroir en Al_{z}Ga_{1-z}As ayant un indice n_{z} de réfraction et une épaisseur d_{z} et d'une autre couche (24) de miroir ayant un indice de réfraction plus petit que celui de la couche (23) de miroir en Al_{z}Ga_{1-z}As, l'autre couche (24) de miroir étant composée respectivement d'une couche (25) en Al_{z}Ga_{1-z}As ayant un indice nₓ de réfraction et une épaisseur dₓ et d'une couche (26) en Al_{y}Ga_{1-y}As ayant un indice n_{y} de réfraction et une épaisseur d_{y} avec une teneur x et y en Al qui est différente et x>y>z, tels que l'on a nₓdₓ+n_{y}d_{y}+n_{z}d_{z} λ/2, avec λ : longueur d'onde d'émission laser de la diode laser.

7. Procédé de production d'une diode (1) laser à résonateur vertical suivant l'une des revendications 3 à 6, **caractérisé en ce que** l'on effectue les stades suivants :
- on produit une succession (2, 4) de couches formant réflecteur de Bragg ayant une majorité de paires (11, 12) de miroirs et une majorité de couches (5 à 10) d'ouverture,
- on oxyde les couches (5 à 10) d'ouverture de leur surface dénudée vers l'intérieur en soumettant la succession (2, 4) de couches formant réflecteur de Bragg ayant les couches (5 à 10) d'ouverture à un recuit dans une atmosphère riche en oxygène.
